(19)

Europäisches
Patentamt

European
Patent Office

Office européen
des brevets

(11) **EP 2 733 497 A1**

(12) **EUROPEAN PATENT APPLICATION**

(43) Date of publication:
21.05.2014 Bulletin 2014/21

(51) Int Cl.:
*G01R 23/20* (2006.01)     *G01R 19/25* (2006.01)

(21) Application number: 13005360.6

(22) Date of filing: 14.11.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 19.11.2012 GB 201220734

(71) Applicant: Optimized Systems and Solutions
Limited
Derby
DE24 8BJ (GB)

(72) Inventor: Shi, Dongfeng
Nottingham, NG9 7EG (GB)

(74) Representative: Yeomans, Victoria Jane Anora et
al
Rolls-Royce plc
Sin-B 38,Intellectual Property
PO Box 31
Moor Lane
Derby DE24 8BJ (GB)

(54) **Method for estimating a frequency of a harmonic in an AC current passing to/from an ac machine**

(57) A method for estimating a frequency of a harmonic in an AC current passing to/from an AC machine. The method includes observing an AC current passing to/from an AC machine that includes a stator and a rotor; measuring phase fluctuations in the observed AC current; and using the measured phase fluctuations to estimate a frequency of a harmonic in the AC current. The method includes using the estimated frequency of the harmonic in the observed AC current to estimate a speed of the rotor of the AC machine. The method may be implemented by a controller, which may include a PC and/or a DSP.

Figure 3

**Description**

This invention relates to a method for estimating a frequency of a harmonic in an AC current passing to/from an AC machine, and associated apparatuses and methods.

Although several signal processing techniques, e.g. fast Fourier transform (FFT), envelope analysis, space vectors and wavelet transform, have been proposed to conduct "sensorless" speed measurement and fault diagnosis for AC machines, the deployment of such monitoring systems in an industrial environment is still rare due, it is thought by the inventor, to some inherent drawbacks within traditional motor current signature analysis procedures.

Firstly, as regards the amplitude and phase spectrum that can be obtained through an FFT of a motor current signal, the inventor has noticed that the phase spectrum is always overlooked in practical applications. The inventor has noticed that by overlooking this phase information, a considerable degree of information about motor behaviour is lost.

Secondly, the inventor has noticed that traditional spectral analysis methods are unable to express the relationship between the motor current signals acquired from different phases. A multi-sensor fusion strategy may be explored to combine motor current signals from each of the three phases to pinpoint the actual faults within induction motors.

Finally, in addition to the specific features of malfunction, the original space vector contains plenty of interference components and noise. It is not, in the view of the inventor, feasible to diagnose the malfunctions by using the original space vector directly.

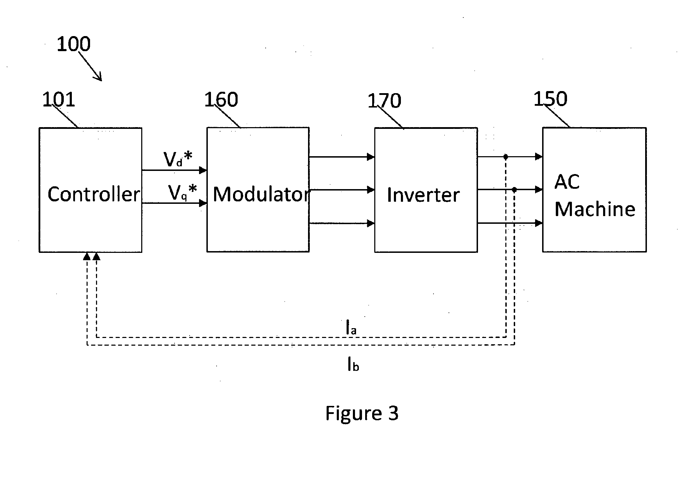

A paper by S. Nandi et al [1] has investigated the phenomenon of rotor slot and other eccentricity related harmonics in the line current of a three phase induction motor. In this paper, harmonic frequencies are identified simply by identifying peaks in the frequency spectrum of an entire line current, see e.g. Fig. 3 of this paper. However, the inventor believes it is difficult to identify harmonic frequencies in this way, since the harmonic frequencies may be obscured by other spectral components in the frequency spectrum. In particular, the amplitude, phase and frequency for a particular frequency component cannot be estimated accurately due to the leakage of conventional FFT.

Another paper by Nandi et al [2] reviews condition monitoring and fault diagnosis of electrical motors.

The present invention has been devised in light of the above considerations.

In general terms, a first aspect of the invention relates to using phase fluctuations in an AC current passing to/from an AC machine to estimate a frequency of a harmonic in the AC current.

Accordingly, a first aspect of the invention may provide a method for estimating a frequency of a harmonic in an AC current passing to/from an AC machine, the method including:

> observing an AC current passing to/from an AC machine that includes a stator and a rotor;
> measuring phase fluctuations in the observed AC current; and
> using the measured phase fluctuations to estimate a frequency of a harmonic in the AC current.

By using phase fluctuations in the AC current to estimate a frequency of a harmonic in the AC current, the inventor has found that the frequency of the harmonic can be more accurately estimated compared with existing methods, e.g. the existing method disclosed in the first paper [1] referred to above.

Using phase fluctuations in the AC current can be interpreted as a "demodulation" approach, because the phase fluctuations can be seen as being demodulated from the observed AC current.

Herein, a "phase fluctuation" in an observed AC current preferably refers to a difference in phase between the observed AC current and a reference AC current. The reference AC current may, for example, be an AC current having a constant (or "ideal") supply frequency. Note here that the "phase fluctuation" may be measured in a 2D reference frame (see below), in which case a "phase fluctuation" may be a difference in phase between a vector representing the observed AC current and a vector representing the reference AC current in the 2D reference frame.

Preferably, measuring phase fluctuations in the observed AC current includes measuring phase fluctuations in the observed AC current so as to obtain a phase fluctuation time series having a plurality of discrete elements, wherein each discrete element of the phase fluctuation time series represents a phase fluctuation in the AC current as measured at a different time. In this case, using the measured phase fluctuations to estimate a harmonic frequency of the AC current preferably includes using the phase fluctuation time series to estimate a harmonic frequency of the AC current.

However, instead of measuring phase fluctuations so as to obtain a time series having a plurality of discrete elements, it is also possible for measuring phase fluctuations to include measuring phase fluctuations in the observed AC current so as to obtain a continuous function representing the measured phase fluctuations, e.g. by interpolating discrete values of the phase fluctuation as measured at different times. In this case, using the measured phase fluctuations to estimate a harmonic frequency of the AC current preferably includes using the continuous function representing the measured phase fluctuations to estimate a harmonic frequency of the AC current.

Preferably, measuring phase fluctuations in the observed AC current is performed in a 2D reference frame. For example, measuring each phase fluctuation in the observed AC current may include, respectively:

converting an observed AC current into a vector representing the observed AC current in a 2D reference frame; and measuring a difference in phase between the vector representing the observed AC current and a vector representing a reference AC current in the 2D reference frame.

Representing single phase and multiphase AC currents as vectors in a 2D reference frame is well known in the art. As is also well known, a 2D reference frame may be either a "stationary" reference frame or a "rotating" reference frame.

A stationary reference frame is typically stationary with respect to a stator of the AC machine. An AC current can be converted into a vector in a stationary reference frame using a "Clarke" transformation, for example.

A rotating reference frame is typically stationary with respect to a rotor of the AC machine (and therefore rotates with respect to the stator) and may sometimes be referred to as a "synchronous" reference frame. An AC current can be converted into a vector in a rotating reference frame using a "Park" transformation, for example.

In the examples described below, a stationary 2D reference frame is used. However, the invention would be equally applicable to a rotating reference frame, as would be appreciated by a person skilled in the art.

A vector representing an AC current in a 2D reference frame may sometimes herein be referred to as a "space vector" for brevity.

Preferably, using the measured phase fluctuations to estimate a frequency of a harmonic in the AC current includes:

converting the measured phase fluctuations into a frequency domain;
using the measured phase fluctuations in the frequency domain to estimate a frequency of a harmonic in the AC current.

As would be appreciated by a skilled person, phase fluctuations may be converted (from the time domain) into a frequency domain using a Fourier transform, which may be a discrete or continuous Fourier transform, depending on whether the phase fluctuations are measured as discrete values or as a continuous function (see above).

If measuring phase fluctuations in the observed AC current includes measuring phase fluctuations in the observed AC current so as to obtain a phase fluctuation time series (see above), using the measured phase fluctuations to estimate a harmonic frequency of the AC current preferably includes:

converting the phase fluctuation time series into a frequency domain to obtain a phase fluctuation frequency series;
using the phase fluctuation frequency series to estimate a frequency of a harmonic in the AC current.

The phase fluctuation time series is preferably converted into the frequency domain using a discrete Fourier transform, such as a fast Fourier transform ("FFT").

If a discrete Fourier transform is used, then converting the phase fluctuation time series may involve applying a window function to the phase fluctuation time series and/or frequency series, e.g. so as to suppress one or more frequency components in the observed AC current relative to a target harmonic in the observed AC current (whose frequency it is wished to estimate). For example, if it is wished to estimate a frequency of an eccentricity harmonic in the observed AC current (see below), then the window function may be configured to suppress other frequency components in the AC current, e.g. slot harmonics.

Window functions are well-known in the art. Examples include a "Hanning" window and a "Blackman" window.

For the avoidance of any doubt, the term "phase fluctuation frequency series" is simply intended to refer to the phase fluctuation time series that has been converted into a frequency domain to provide series of discrete elements that are a function of frequency or a variable that is analogous to frequency. By way of example, the discrete elements of the phase fluctuation frequency series may be a function of a variable k that is a multiple of frequency (and therefore analogous to frequency), as is the case for the examples discussed below.

Preferably, using the phase fluctuation frequency series to estimate a frequency of a harmonic in the AC current includes:

identifying a peak in the phase fluctuation frequency series, wherein the peak is caused by a harmonic in the observed AC current; and
estimating the frequency of the harmonic based on the identified peak.

As would be recognised by a skilled person, then the frequency of a harmonic in the observed AC current may fall between two adjacent elements in the phase fluctuation frequency series.

Accordingly, using the phase fluctuation frequency series to estimate a frequency of a harmonic in the AC current preferably includes:

identifying adjacent peaks in the phase fluctuation frequency series, wherein the adjacent peaks are caused by a harmonic in the observed AC current; and
estimating the frequency of the harmonic by interpolating between the adjacent peaks.

Of course, if the frequency of a harmonic in the observed AC current falls exactly on an element in the phase fluctuation frequency series, then interpolation might not be required to obtain a more accurate estimate for the frequency, e.g. when the number of sampling points is the integral times of the sampling frequency.

Interpolation is, of course, a well-known technique, but has not previously been considered in this context. The exact method of interpolating between the adjacent peaks may, for example, depend on a type of window function involved in converting the phase fluctuation time series, if such a window function is used (see above). For an example of how interpolating between adjacent peaks can be achieved, please refer to Equations (17) and (20) below.

In the specific examples discussed below, an FFT is used to obtain the phase fluctuation frequency series, and then the frequency of a harmonic in the AC current is estimated by interpolating between adjacent peaks in the frequency series in the manner discussed above. This combination of FFT and interpolation is referred to below as an interpolation fast Fourier transform or "IFFT" technique. However, it should be evident from the discussion above that other modes of converting phase fluctuations to the frequency domain and other methods of frequency estimation are possible within the scope of the invention.

If measuring phase fluctuations in the observed AC current includes measuring phase fluctuations in the observed AC current so as to obtain a continuous function representing the measured phase fluctuations (see above), using the measured phase fluctuations to estimate a harmonic frequency of the AC current preferably includes:

converting the continuous function representing the measured phase fluctuations (in the time domain) into a frequency domain to obtain a continuous function representing the measured phase fluctuations in the frequency domain;
using the continuous function representing the measured phase fluctuations in the frequency domain to estimate a frequency of a harmonic in the AC current.

Here, the continuous function is preferably converted into the frequency domain using a (continuous) Fourier transform.

The method may also include estimating an amplitude and/or phase of the phase fluctuations in the frequency domain at the estimated frequency (of the harmonic in the AC current). This may involve, for example, estimating an amplitude and/or phase of the phase fluctuation frequency series at the estimated frequency of the harmonic in the AC current using Equations (18)-(20), described below.

Preferably, the method includes using any one or more of the estimated frequency of the harmonic in the observed AC current, an estimated amplitude of the phase fluctuations in the frequency domain at the estimated frequency, and an estimated phase of the phase fluctuations in the frequency domain at the estimated frequency, to determine one or more conditions of the AC machine, e.g. for diagnostic purposes.

The one of more conditions of the AC machine may, for example, include an estimated speed of the rotor of the AC machine, which may e.g. be estimated using the estimated frequency of the harmonic in the observed AC current.

Thus, the method may include using the estimated frequency of the harmonic in the observed AC current to estimate a speed of the rotor of the AC machine.

In this way, the method may be used to achieve "sensorless" speed measurement.

As explained in more detail below, it is particularly easy to estimate the speed of the rotor if the harmonic in the observed AC current (whose frequency is estimated) is an eccentricity harmonic.

The one of more conditions of the AC machine may, for example, include whether there is a fault with the AC machine, which may e.g. be determined using an estimated amplitude and/or an estimated phase of the phase fluctuations in the frequency domain at the estimated frequency.

Accordingly, the method may include using an estimated amplitude and/or an estimated phase of the phase fluctuations in the frequency domain at the estimated frequency, to determine whether there is a fault with the AC machine. Determining whether there is a fault may, for example, include determining:

whether there is an alignment fault (e.g. an angular and/or parallel misalignment) with the AC machine; and/or
whether there is a short circuit fault with the AC machine.

Determining whether there is a fault with the AC machine may involve:

using an estimated amplitude and/or an estimated phase of the phase fluctuations in the frequency domain at the estimated frequency, to obtain a vector representing the AC current in a 2D reference frame; and

using the vector representing the AC current in the 2D reference frame to estimate whether there is a fault with the AC machine.

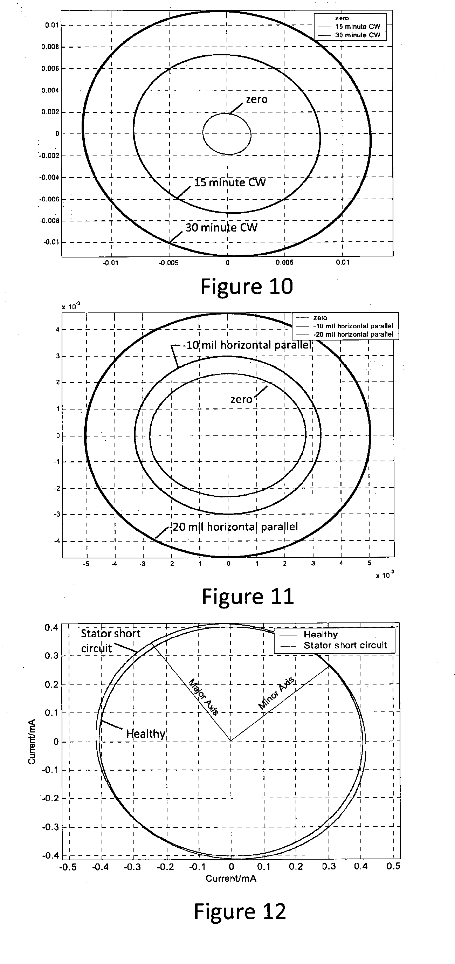

Such a vector may be obtained by feeding the results of Equations (17)-(19) into Equation (4), discussed below, for example. Such a vector can be seen as a "purified" space vector representing the AC current, since it effectively represents a reference voltage as perturbed by the harmonic whose frequency has been estimated. Examples of how a "purified" space vector such as this can be used to identify fault conditions are discussed below with reference to Fig. 10, Fig. 11 and Fig. 12.

Preferably, the harmonic in the observed AC current (whose frequency is estimated) is an eccentricity harmonic in the observed AC current.

The eccentricity harmonic in the observed AC current (whose frequency is estimated) may be a primary, secondary, or higher order eccentricity harmonic. Usually, a primary or secondary eccentricity harmonic frequency is dominant, and therefore will usually be the eccentricity harmonic whose frequency is estimated. However, other eccentricity harmonics may be dominant in certain operating conditions.

A particular advantage of using the measured phase fluctuations to estimate a frequency of an eccentricity harmonic in the AC current is that an eccentricity harmonic frequency can be used to estimate a speed of a rotor of the AC machine since, in general:

the speed of a rotor of the AC machine (revolutions per unit time) can be taken as being the same as a primary eccentricity harmonic frequency;

the speed of a rotor of the AC machine (revolutions per unit time) can be taken as being the half of a secondary eccentricity harmonic frequency; and so on.

Herein, when a given parameter is described as being "observed", it is intended to cover both the possibility of a value of the parameter that has either been estimated and the possibility of a value of the parameter that has been estimated in some other way (e.g. by directly/indirectly measuring the parameter). For example, a given parameter may be "observed" based on one or more measurements from an apparatus including the AC machine and/or based on one or more parameters (e.g. reference values) used to control the AC machine.

Accordingly, observing an AC current passing to/from an AC machine may involve, for example:

measuring an AC current passing to/from an AC machine; or

obtaining a reference value representing an AC current passing to/from an AC machine, wherein the reference value is used to control the AC machine.

The AC current may be a single phase AC current or a multiphase (e.g. three-phase) AC current. For the avoidance of any doubt, observing the AC current may involve observing a voltage and/or current of one or more phases of the AC current.

The method may be performed whilst the AC machine is operated as an AC induction motor, during which the observed AC current will in general be an AC current passing to the AC machine so as to cause the rotor to rotate with respect to the stator, and/or whilst the AC machine is operated as an AC induction generator, during which the observed AC current will in general be an AC current passing from the AC machine, the AC current having been produced by the AC machine as a result of the rotor rotating with respect to the stator.

The method may be implemented by a controller, which may include a PC and/or a DSP (digital signal processor), for example.

The method may also include producing, at the controller, control signals for controlling the AC machine.

The controller may have a motor mode in which the AC machine is operated as an AC induction motor and/or a generator mode in which the AC machine is operated as an AC induction generator.

In a motor mode of the controller, the control signals may take the form of reference values used to control the AC machine. The reference values may e.g. take the form of reference voltages, which may be produced in the 2D reference frame referred to above.

In the motor mode of the controller, the control signals may be converted by a modulator into switching signals for controlling one or more switches of an inverter and the switching signals may be converted by the inverter into an AC voltage that is supplied to the AC machine.

The controller may be included in an apparatus including the AC machine, and optionally including the modulator and inverter referred to above.

A second aspect of the invention may provide a controller for implementing a method according to the first aspect of the invention.

Accordingly, the second aspect of the invention may provide a controller for an AC machine, the controller being configured to:

> observe an AC current passing to/from an AC machine that includes a stator and a rotor;
> measure phase fluctuations in the observed AC current; and
> use the measured phase fluctuations to estimate a frequency of a harmonic in the AC current.

The controller may be configured to implement, or have means for implementing, any method step described in connection with any aspect of the invention described herein.

For example, the controller may be configured to estimate an amplitude and/or phase of the phase fluctuations in the frequency domain at the estimated frequency (of the harmonic in the AC current).

For example, the controller may be configured to use any one or more of the estimated frequency of the harmonic in the observed AC current, an estimated amplitude of the phase fluctuations in the frequency domain at the estimated frequency, and an estimated phase of the phase fluctuations in the frequency domain at the estimated frequency, to determine one or more conditions of the AC machine, e.g. for diagnostic purposes.

For example, the controller may be configured to use the estimated frequency of the harmonic in the observed AC current to estimate a speed of the rotor of the AC machine.

For example, the controller may be configured to use an estimated amplitude and/or an estimated phase of the phase fluctuations in the frequency domain at the estimated frequency, to determine whether there is a fault with the AC machine.

For example, the controller may include a PC and/or a DSP (digital signal processor).

For example, the controller may be configured to produce control signals for controlling the AC machine.

For example, the controller may have a motor mode in which the AC machine is operated as an AC induction motor and/or a generator mode in which the AC machine is operated as an AC induction generator.

The controller may be included in an apparatus including the AC machine.

Thus, the second aspect of the invention may provide an apparatus including an AC machine that includes a stator and a rotor, and a controller configured to:

> observe an AC current passing to/from the AC machine;
> measure phase fluctuations in the observed AC current; and
> use the measured phase fluctuations to estimate a frequency of a harmonic in the AC current.

The controller may be configured to implement, or have means for implementing, any method step described in connection with any aspect of the invention described herein.

For example, the apparatus may include a modulator configured to convert switching signals for converting control signals produced by the controller into switching signals for controlling one or more switches of an inverter.

For example, the apparatus may include an inverter having one or more switches configured to convert switching signals from the modulator into an AC voltage that is supplied to the AC machine.

A third aspect of the invention may include machine-executable instructions configured to cause a controller, or an apparatus including a controller, to perform any method according to the first aspect of the invention.

It is to be noted that a controller or apparatus according to the second aspect of the invention does not require any new hardware compared with existing controllers/apparatuses. That is, a controller/apparatus according to the second aspect of the invention could be obtained by reconfiguring existing hardware.

A fourth aspect of the invention may therefore provide a method of configuring a controller, or an apparatus including a controller, to provide a controller or apparatus according to the second aspect of the invention.

The invention also includes any combination of the aspects and preferred features described except where such a combination is clearly impermissible or expressly avoided.

Examples of our proposals are discussed below, with reference to the accompanying drawings in which:

Fig. 1 is a diagram illustrating amplitude and phase fluctuations in a current supplied to an AC machine operated as an AC induction motor in the presence of eccentricity harmonics.

Fig. 2 illustrates amplitude $y(k)$ (Fig. 2(a)) and phase $\alpha(k)$ (Fig. 2(b)) for a fast Fourier transform of a time series acquired by sampling a sinusoidal signal at a sampling frequency $\Delta f$.

Fig. 3 is a schematic diagram of an apparatus including a controller for an AC machine.

Fig. 4 is a simulated waveform of motor current during initial acceleration of a motor.

Fig. 5 is a simulated waveform of phase fluctuations of the motor current shown in Fig. 4.

Fig. 6 is a short time Fourier transform of the phase fluctuations shown in Fig. 5.

Fig. 7 is a graph comparing motor speed estimated according to the interpolated fast Fourier transform technique taught herein (o) compared with simulated motor speed (solid line).

Fig. 8 is a short time Fourier transform of the phase fluctuations of the experimental motor during initial acceleration of the motor.

Fig. 9 is a graph comparing motor speed estimated according to the interpolated fast Fourier transform technique taught herein (o) compared with motor speed as measured by the encoder (solid line).

Fig. 10 shows purified space vectors obtained for different angular misalignments.

Fig. 11 shows purified space vectors obtained for different parallel misalignments.

Fig. 12 shows purified space vectors obtained for a with a stator short circuit and without a stator short circuit.

In general, the examples discussed below relate to a new "sensorless" scheme, in which a "purified" space vector can be used e.g. to estimate the speed of a rotor of and/or diagnose faults with an AC induction motor. In the examples described below, this scheme uses a "demodulation" approach combined with an interpolated fast Fourier transform ("IFFT") technique to obtain a "purified" space vector. As demonstrated below, the proposed purified space vector can be effective in estimating the speed of a rotor of an AC induction motor under low speed as well as during speed transient periods. Also as demonstrated below, the purified space vector can be used to diagnose faults with an AC induction motor, e.g. to estimate whether there is a coupling misalignment fault and/or a stator short circuit. Advantageously, the demodulation and IFFT technique described below can be efficiently implemented through PC or DSP programming, and has a low requirement on calculation time, e.g. only 0.58 ms is required to conduct a 1024-point real FFT on a Motorola floating-point DSP (model 96002). It is envisaged that the scheme will be applicable to both real-time (e.g. "sensorless") speed estimation and/or fault diagnosis in AC machines, whether motor drives or generators.

In a general sense, the discussion below can be seen as providing a new space vector purification technique based on a high-resolution spectrum combined with demodulation procedure to accurately calculate frequency, phase and amplitude of all frequency components in the motor current signal.

In some examples, this invention may seek to overcome drawbacks in conventional signal processing and feature extraction techniques, and may provide a scheme for purifying and extracting features from an original space vector, e.g. for use in sensorless speed measurement and/or fault diagnosis for AC machines such as AC induction motors.

## I. ECCENTRICITY AND SLOT HARMONICS

Typically, an AC current passing to an AC machine operated as an AC induction motor is a multi-phase AC current, usually a three-phase AC current. The frequency of the AC current supplied to an AC machine operated as an AC induction motor may be referred to as a "supply frequency", and is typically 50Hz or 60Hz. In general, each phase of the AC current passing to an AC machine operated as an AC induction motor includes a supply frequency related component and other frequency components, which are generally caused by imperfections in the electrical supply.

An example of a frequency component caused by imperfections in the electrical supply is the "saliency" harmonic. The saliency harmonic is a speed-related frequency component, in that that harmonic is dependent on the speed of a rotor of the AC machine. The saliency harmonic is typically caused by variations in air-gap permeance due, e.g. to rotor slotting or eccentricity. The rotor slotting or eccentricity-related saliency harmonics are typically modulated by the supply frequency of the stator current when the induction motor is running. Owing to the presence of the eccentricity and rotor slots, saliency harmonics may appear at frequency $f_h$ in the frequency spectrum of motor current, with $f_h$ being expressed according to a well-known equation, e.g. as:

$$f_h = f_s\left( (kR + n_d)\left(\frac{1-s}{p}\right) + n_w \right)$$

(1)

$n_d=0$     for static eccentricity;
$n_d=1,2,3$     for dynamic eccentricity;
$f_s$     fundamental supply frequency(Hz);
R     number of rotor slots;
s     slip;
p     number of pole pairs;
k     any positive integer;
$n_w=1, 3, 5$     the air-gap magnetomotive force ("MMF") harmonic order.

As can be seen from Equation (1) above, the parameters that estimate saliency harmonics are generally independent of changes in operational parameters, e.g. load and temperature. Since multiple slot harmonics are usually present in the motor current as illustrated in Equation (1), several no-load tests (tests with no load on the motor) usually have to be conducted in order to determine which harmonic component represents the "real" primary slot harmonic, which may be characterized by its amplitude that is consistently the strongest among all the harmonics. Consequently, it is difficult to estimate the motor speed accurately in practice using slot harmonics.

In contrast to slot harmonics, eccentricity harmonics generally exist at any non-zero shaft speed and, advantageously, are independent of the number of slots. There are two types of air-gap eccentricity in induction motors: static and dynamic air-gap eccentricity. Static eccentricity can occur due to incorrect positioning of the stator or rotor at the commissioning stage. Dynamic eccentricity can be generated from a bent rotor, worn bearings, or coupling misalignment. Taking only static eccentricity into account, side-band eccentricity related components $f_h$ will appear around the power supply frequency in the motor current spectrum, and Equation (1) can be rewritten as:

$$f_h = f_s\left(1 \pm m\left(\frac{1-s}{p}\right)\right)$$

(2)

where m is the order of the eccentricity-related harmonic, which can be any positive integer.

In general, the strongest eccentricity harmonic (which may or may not be m=1) can be selected as the primary eccentricity harmonic used for motor speed estimation.

Apparently, there exists a modulated relationship between the power supply component and the eccentricity harmonic. Since the amplitude of the power supply component ($f_s$) is, in general, much higher than that of the primary eccentricity harmonic component ($f_h$), the primary eccentricity harmonic component is mostly obscured/masked in the motor current spectrum. As explained in the next section below, the inventor has solved this problem by developing a reliable demodulation approach that is able to accurately extract eccentricity harmonic information from the motor current signals, e.g. for the purpose of sensorless motor speed estimation or fault diagnosis.

## II. PURIFIED SPACE VECTOR

**Demodulation**

The space vector [3] is an effective format to describe three-phase induction motor phenomena in the two-dimensional representation. As a function of a three-phase AC motor current ($i_a$, $i_b$, $i_c$), the space vector ($i_d$, iq) can be expressed as:

$$i_d = \sqrt{\frac{2}{3}}i_a - \frac{1}{\sqrt{6}}i_b - \frac{1}{\sqrt{6}}i_c$$

$$i_q = \frac{1}{\sqrt{2}}i_b - \frac{1}{\sqrt{2}}i_c$$

(3)

A space vector representing an observed AC current supplied to an AC machine operated as an AC induction motor in the d-q domain, referred to herein as an "observed" or "motor current" space vector, will, in general, be close to a circle if only the balanced power supply frequency component ($f_s$) is considered. However, in a real-life situation, due to the presence of noise interference, imperfections and speed-related harmonics, some fluctuations may occur in the motor current space vector. Since the amplitude of speed-related harmonics is much smaller than supply frequency, the fluctuations in the motor current space vector caused by speed-related harmonics are not obvious.

The motor current space vector can be expressed as the sum of several frequency components and noise component in d-q domain in Equation (4):

$$\vec{I} = \sum A_n \sin(2\pi f_n t + \alpha_n) + j \sum B_n \sin(2\pi f_n t + \beta_n) + \vec{I}_{noise} \qquad (4)$$

where $j = \sqrt{-1}$.

Furthermore, this motor current space vector can be purified and decomposed into positive and negative sequence components and expressed as:

$$\vec{I} = \sum \left( P_n e^{j2\pi f_n t} + P_{-n} e^{-j2\pi f_n t} \right) \qquad (5)$$

where $P_n$ and $P_{-n}$ indicate the amplitude of positive and negative sequence components, respectively and can be calculated by:

$$P_n = \sqrt{A_n^2 + B_n^2 + 2|A_n B_n \sin(\alpha_n - \beta_n)|} \quad , \qquad (6)$$

$$P_{-n} = \sqrt{A_n^2 + B_n^2 - 2|A_n B_n \sin(\alpha_n - \beta_n)|} \quad . \qquad (7)$$

The amplitude, frequency and phase of power supply frequency components can be calculated by the high-resolution spectrum technique. However, since the amplitude of speed-related harmonic components is much smaller than supply frequency component, the inventor believes that it is not desirable to calculate amplitude, frequency and phase of speed related harmonic components directly from the observed space vectors.

In view of these factors, the inventor has devised an efficient procedure to demodulate a weak speed-related harmonic from the dominant supply frequency component. This efficient demodulation approach is based on amplitude fluctuations and can be expressed as:

$$B = \sqrt{i_d^2 + i_q^2} \qquad (8)$$

Hence, the dominant supply frequency component can be removed as a direct component (DC) such that residual signal contains the speed-related harmonic component. Moreover, the phase envelope can be presented to extract a speed related harmonic component through calculating the instantaneous phase angle in d-q domain as well. Obviously, instantaneous phase angle of the motor current space vector can be defined as

$$\phi(t) = \arctan(\frac{\dot{i}_q}{\dot{i}_d}) \qquad (9)$$

The time interval between adjacent points in the space vector will not be constant due to the presence of an eccentricity harmonic component and can be expressed as

$$\Delta t = 2\pi \frac{f_c}{f_s} + \tau$$

(10)

where fs and fc is the supply frequency and sampling frequency respectively, and $\tau$ denotes the phase fluctuation due to the presence of eccentricity harmonics.

The phase fluctuation $\tau_i$ at time instant i can be defined as the difference between instantaneous phase angle of motor current space vector (representing an observed AC current) and reference space vector (representing a reference AC current), which rotates at uniform supply frequency. Thus, the phase fluctuation $\tau_i$ may be expressed as

$$\tau_i = \phi_i - 2\pi \frac{f_c}{f_s} rem\left( i, \frac{f_c}{f_s} \right)$$

(11)

where $\phi_i$ denotes the instantaneous phase angles and can be obtained by Equation (10), and $rem(i, f_c/f_s)$ denotes the remainder from the division of i by $f_c/f_s$.

The phase fluctuation is preferably obtained as a time series. In order to reduce estimation error, the sample frequency at which the time series is obtained is preferably an integer multiple of the supply frequency, e.g. 3600Hz (if the supply frequency is 60Hz).

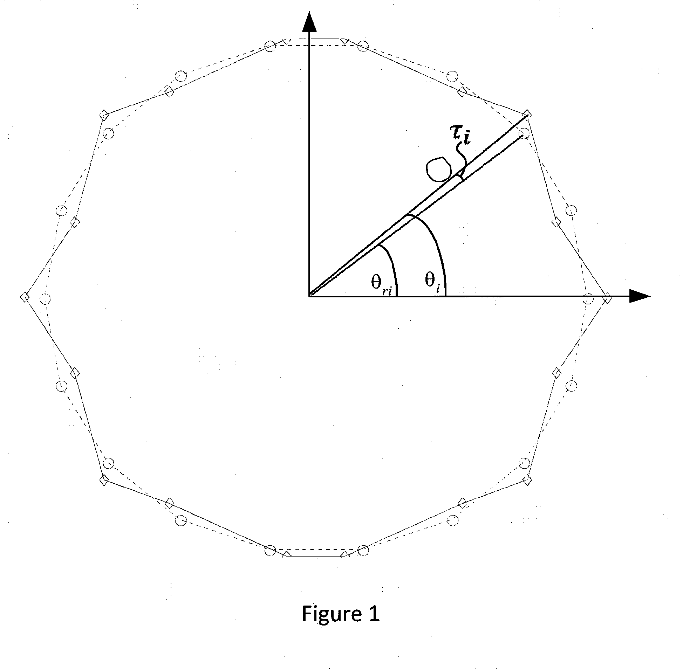

Fig. 1 is a diagram illustrating amplitude and phase fluctuations in a current supplied to an AC machine operated as an AC induction motor ("motor current") in the presence of eccentricity harmonics.

In Fig. 1, the motor current space vector representing an observed AC current is represented by a solid line. This can be viewed as being the "real" or "actual" signal.

A reference space vector representing a reference AC current having a constant supply frequency is represented by a dashed line. This can be viewed as the "ideal" or "reference" signal.

In Fig. 1, individual samples of the motor current space vector are indicated by diamonds, whereas individual samples of the reference space vector are indicated by circles.

The phase angles of the motor current space vector ($\theta_i$) and the reference space vector ($\theta_{ri}$) are marked clearly in Fig. 1, along with the difference between these values, this difference being the (instantaneous) phase fluctuation $\tau_i$ described above.

The phase fluctuation $\tau_i$ in the observed AC current can be measured using Equation (11) at different times so as to obtain a phase fluctuation time series having a plurality of discrete elements, wherein each discrete element of the phase fluctuation time series represents a phase fluctuation in the AC current as measured at a different time. The motor speed can then be estimated through a fast Fourier transform of this time series into the frequency domain, e.g. in a manner that will now be described.

**"High-resolution" Spectrum**

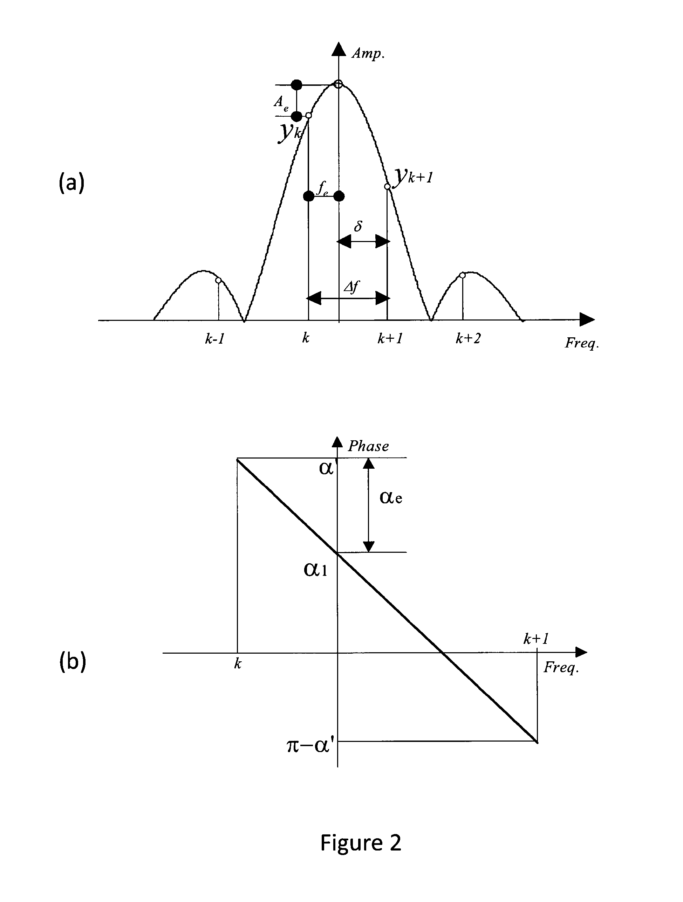

Fig. 2 illustrates amplitude $y(k)$ (Fig. 2(a)) and phase $\alpha(k)$ (Fig. 2(b)) for an FFT of a time series acquired by sampling a sinusoidal signal (i.e. a signal that is sinusoidal with respect to time) at a sampling frequency $\Delta f$.

The Fourier transform is a powerful signal-processing tool to analyse the composition of signals in frequency domain. However, due to signal truncation in time domain, leakage effects will, in general, appear in discrete Fourier spectra, even if a window function is used. In addition, an FFT spectrum is the result of a continuous spectrum sampled with a frequency interval ($\Delta f$).

In general, the "real" spectrum line caused by a given frequency component may not be located in the centre of the main-lobe of the FFT spectrum, in which case the estimated frequency, amplitude and phase of a signal component estimated from the FFT may not be accurate. This is the so-called "comb-effect", which is demonstrated by Fig. 2.

In Fig. 2, it is to be noted that both the amplitude $y(k)$ and phase $\alpha(k)$ of the FFT are functions of $k$, where k is analogous to frequency $f$ (specifically, $f = k \times \Delta f$).

With reference to Fig. 2, only if the sampling frequency $\Delta f$ used to obtain the time series is an exact multiple of the actual frequency $f_{signal}$ of the sinusoidal signal used to create the FFT spectrum, will the largest peak for the FFT of the time series be located at the centre of main-lobe and equal to the actual frequency $f_{signal}$. Otherwise, the "comb-effect" can lead to serious error in estimating the frequency, amplitude, and phase of the sinusoidal signal from the FFT spectrum.

If only a single sinusoidal signal is considered, the corresponding error of frequency, amplitude and phase of single sinusoidal signal can be estimated as [4]:

$$f_e = \min \left( \left| k\Delta f - f \right|, \left| (k+1)\Delta f - f \right| \right) \tag{12}$$

$$A_e = A_1 \cdot (W(f_e) - 1) \tag{13}$$

$$\alpha_e = \frac{\pi f_e}{\Delta f} \tag{14}$$

where, W(f) is the Fourier transform of any window function used.

It should be apparent from the above discussion that errors in frequency, amplitude and phase estimated using an FFT of an acquired time series can be large. In particular, the frequency error can be up to the sample frequency $\Delta f$, which can therefore be viewed as the "resolution" of the spectrum.

In view of these factors, a new "high-resolution" spectrum based on interpolation is preferably introduced to estimate the precise frequency, amplitude and phase of the FFT of a signal, such as a sinusoidal signal. Given N sample values of the single sinusoidal signal to obtain the time series x(0),x(1)...... x(N-1), the discrete Fourier spectrum can be calculated by:

$$X(k) = \frac{1}{N} \sum_{n=0}^{N-1} x(n) e^{-j2\pi nk/N} \tag{15}$$

Adjacent peaks can be detected at $y_k$ and $y_{k+1}$ as shown in Fig. 2, and the corresponding frequency can be denoted as $k \times \Delta f$ and $(k + 1) \times \Delta f$ respectively. Due to the symmetry of window functions, the following equation can be obtained:

$$\frac{y_k}{y_{k+1}} = \frac{W(\delta)}{W(\Delta f - \delta)} \tag{16}$$

Where $\delta$ is the distance between the right frequency and the correct signal frequency $f_{signal}$.

A more accurate estimate of the sinusoidal signal can be estimated by interpolating between the peaks, e.g. according to the equation:

$$f_0 = (k+1)\Delta f - \delta \tag{17}$$

Corresponding estimates for the amplitude and phase of the sinusoidal signal at the frequency estimated by interpolation can be calculated respectively according to:

$$A = \frac{y_{k+1}}{W(\delta)} \tag{18}$$

$$\alpha = \tan^{-1}\left(\frac{I_{k+1}}{R_{k+1}}\right) + \delta\pi \tag{19}$$

Thus, if the value of $\delta$ can be obtained, frequency, amplitude and phase for the phase fluctuations in the frequency domain can be estimated more accurately using Equation (17)-(19).

The value of $\delta$ will in general depends on the type of window function used to obtain the FFT. In this example, since the Hanning window is employed to calculate the FFT of signal, $\delta$ can be estimated as:

$$\delta = \frac{2y_{k-}y_{k+1}}{y_{k+1} + y_k} \tag{20}$$

Corresponding equations for other window functions could easily be calculated by a person skilled in the art.

This discussion shows that interpolation can be used to calculate more accurate values of frequency, amplitude and phase for the FFT of a time series acquired by sampling a signal at a given sampling frequency.

## III. EXAMPLE APPARATUS

Fig. 3 is a schematic diagram of an apparatus 100 including a controller 101 for an AC machine 150.

The apparatus 100 preferably includes a modulator 160 and an inverter 170. The AC machine includes a stator and a rotor (not shown).

The controller 101 is configured to produce control signals for controlling the AC machine 150. The controller may have a motor mode in which the AC machine is operated as a motor and/or a generator mode in which the AC machine is operated as a generator.

In Fig. 3, the controller 101 is shown in a motor mode, in which the AC machine 150 is operated as an AC induction motor, with an AC current passing to the AC machine so as to cause the rotor to rotate with respect to the stator.

In the motor mode of the controller 101, the control signals may take the form of reference values used to control the AC machine 150. The reference values may e.g. take the form of reference voltages $v_d{}^*$, $v_q{}^*$ which may be produced in a 2D reference frame, such as a "dq" reference frame.

The control signals may be converted by the modulator 160 into switching signals for controlling one or more switches of the inverter 170, which may be a pulse width modulator ("PWM") or a space vector modulator ("SVM"), for example.

The switching signals may be converted by the inverter 170 into an AC voltage that is supplied to the AC machine 150, so as to operate the AC machine 150 as an AC induction motor.

In Fig. 3, the AC current supplied to the AC machine 150 is depicted as being a three-phase AC current. However, in other embodiments, the AC current supplied to the AC machine 150 could of course be a single-phase or other multi-phase AC current.

Also, although Fig. 3 shows the controller 101 in a motor mode, a skilled person would readily appreciate that the controller 101 could equally be shown in a generator mode in which the AC machine 150 is operated as an AC induction generator, with current being produced by the AC machine as a result of the rotor rotating with respect to the stator. In either case, the same principles (described in more detail below) can be used to estimate a frequency of a harmonic in an AC current passing to/from the AC machine.

The controller 101 is configured to observe an AC current passing to/from the AC machine 150. Observing the AC current passing to/from the AC machine 150 may involve, for example:

measuring an AC current passing to/from the AC machine 150 (as shown by the dotted line in Fig. 3); or
obtaining a reference value representing an AC current passing to/from the AC machine 150, wherein the reference value is used to control the AC machine 150 (e.g. using reference voltages $v_d{}^*$, $v_q{}^*$ described above).

Preferably, the controller 101 is configured to measure phase fluctuations in the observed AC current, preferably so as to obtain a phase fluctuation time series. In practice, each phase fluctuation may be measured using Equation (11) described above, for example.

Preferably, the controller 101 is also configured to use the measured phase fluctuations to estimate a frequency of a harmonic in the AC current, e.g. by: converting the phase fluctuation time series into a frequency domain to obtain a phase fluctuation frequency series, preferably using a discrete Fourier transform, such as an FFT; and using the phase fluctuation frequency series to estimate a frequency of a harmonic in the AC current.

Preferably, the harmonic (whose frequency is estimated) is an eccentricity harmonic in the observed AC current.

Converting the phase fluctuation time series may involve applying a window function to the phase fluctuation time series and/or frequency series, e.g. so as to suppress one or more frequency components in the observed AC current relative to a target harmonic in the observed AC current (whose frequency it is wished to estimate). For example, if it is wished to estimate a frequency of an eccentricity harmonic in the observed AC current (see below), then the window function may be configured to suppress other frequency components, e.g. multiple slot harmonics.

In the discussion above, the use of a "Hanning" window was assumed, but other window functions are available.

Preferably, using the phase fluctuation frequency series to estimate a frequency of a harmonic in the AC current includes: identifying adjacent peaks in the phase fluctuation frequency series, wherein the adjacent peaks are caused by a harmonic in the observed AC current; and estimating the frequency of the harmonic by interpolating between the adjacent peaks.

The exact method of interpolation may, for example, depend on a type of window function that may have been applied to the phase fluctuation frequency series (see above). In the case that a Hanning window is used, Equation (20) above may be used to achieve this interpolation.

The amplitude and/or phase of the phase fluctuations in the frequency domain at the estimated frequency of the harmonic in the AC current are preferably also estimated, e.g. using Equations (18) and (19) described above.

Preferably, the controller is configured to use any one or more of the estimated frequency of the harmonic in the observed AC current, an estimated amplitude of the phase fluctuations in the frequency domain at the estimated frequency and/or an estimated phase of the phase fluctuations in the frequency domain at the estimated frequency, to estimate a speed of the rotor of the AC machine and/or determine whether there is a fault with the AC machine.

Example faults whose existence could be estimated in this way are discussed below with respect to Fig. 10, Fig. 11 and Fig. 12.

## IV. SIMULATION RESULTS

To demonstrate that the IFFT technique described herein is effective in the detection of motor speed when an AC induction motor is operating under transient conditions, such as starting acceleration or shut-down processes, a simulated motor current was generated using the induction motor model reported in [5].

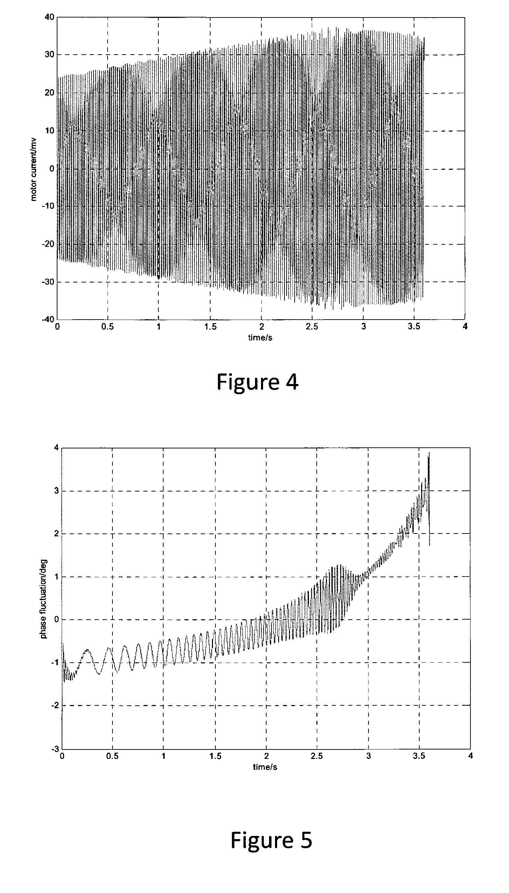

The results of this simulation are shown in Figs. 4-6, which will now be described.

Fig. 4 is a simulated waveform of motor current during initial acceleration of a motor ("run-up" stage).

As can be seen from Fig. 4, since the amplitude of motor current increases during acceleration, fluctuations in amplitude of the motor current caused by harmonic components are almost completely obscured. Therefore, it is not thought feasible to estimate motor speed using amplitude fluctuations.

Fig. 5 is a simulated waveform of phase fluctuations of the motor current shown in Fig. 4, i.e. during initial acceleration of a motor.

As can be seen from Fig. 5, the phase fluctuations can be seen much more clearly than the fluctuations in amplitude shown in Fig. 4, i.e. such that the phase fluctuations are largely unaffected by the increasing motor current. This property of phase fluctuations means that the phase, and can be extracted by the demodulation procedure described above.

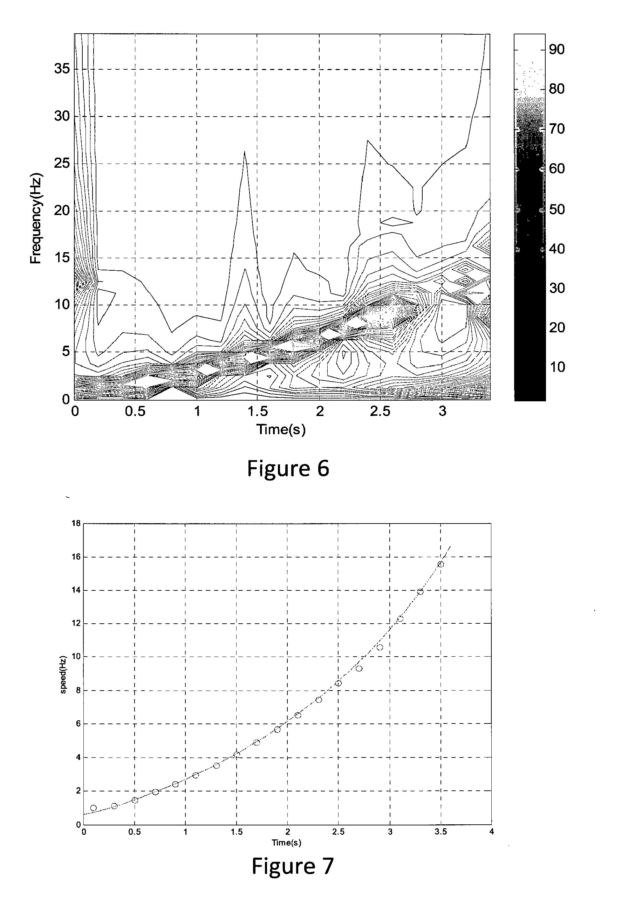

Fig. 6 is a short time Fourier transform ("STFT") of the phase fluctuations shown in Fig. 5.

STFT is a standard technique well known to those skilled in the art. The time scale in Fig. 6 shows time from start of the motor (at which point, motor speed is zero).

Fig. 6 demonstrates that the phase fluctuations contain information concerning the speed of a rotor of the motor

In Fig. 6, the primary eccentricity harmonic is the dominant eccentricity harmonic.

In practice, an additional trial run can be performed to determine the order of the dominant eccentricity harmonic.

Fig. 6 shows that the motor accelerated from 0 to 15Hz. Although the speed of a rotor of the AC machine can be taken as being the same as a primary eccentricity harmonic frequency, since the frequency resolution is extremely low in STFT, it is difficult to accurately estimate the speed of the motor from the STFT shown in Fig. 6.

However, by applying the methods taught herein to obtain a more accurate (or "high resolution") spectrum in the frequency domain, the speed of the induction motor can be estimated more accurately.

Fig. 7 is a graph comparing motor speed as estimated according to the interpolated fast Fourier transform ("IFFT") technique taught herein (o) compared with simulated motor speed (solid line).

As can be seen from Fig. 7, the speeds estimated using the "high-resolution" methods taught herein agree very well with the "real" speed from the motor simulation model.

## V. EXPERIMENTAL RESULTS

To evaluate the performance of the IFFT technique in a real AC machine, several experiments were conducted using an ABB motor, under constant speed and during acceleration. An optical incremental encoder with 1,024 pulses per revolution was coupled to the motor shaft for direct, comparative measurement of the motor speed. The experiments were conducted with a three-phase Variac transformer to vary the supply voltage and control the run-up processes of a pumping system. The data acquisition system was based on a Pentium 266MHz PC, fitted with an Amplicon PC30G 12-bit 100kHz plug-in card. Two sets of data were collected from the motor by HP VEE software package and processed by the Matlab program. A sixth-order analog Butterworth anti-aliasing filter with a cut-off frequency at 100Hz was employed to pre-process the current signal and remove interference frequency component, such as higher harmonics of the supply frequency (whilst retaining the supply frequency and eccentricity harmonics). The three-phase motor current signal and instantaneous angular speed signal were A/D converted and sampled at a rate of 6,600 Hz.

Table 1 illustrates the speed estimated by the demodulation approach based on the space vector and IFFT technique taught herein, compared with the speed measured by the encoder when the motor was running at constant speeds.

|  | 1 | 2 | 3 | 4 | 5 | 6 | 7 |
|---|---|---|---|---|---|---|---|
| Encoder(Hz) | 1.07 | 3.32 | 8.10 | 12.07 | 17.13 | 20.76 | 22.54 |
| Estimate(Hz) | 1.07 | 3.29 | 8.11 | 12.10 | 17.12 | 20.76 | 22.46 |

Table 1 Comparison of sensorless motor speed estimates with encoder (Motor controlled by a Variac transformer at constant speeds)

It can be seen from Table 1 that the speed obtained by the IFFT technique taught herein is in good agreement with the speed measured by the shaft-encoder, for a speed as low as 1 Hz.

Whilst the motor speeds shown in Table 1 are in units of revolutions per second, such speeds are often provided in units of revolutions per minute. Of course, multiplying a speed in units of revolutions per second will obtain the same speed in units of revolutions per minute.

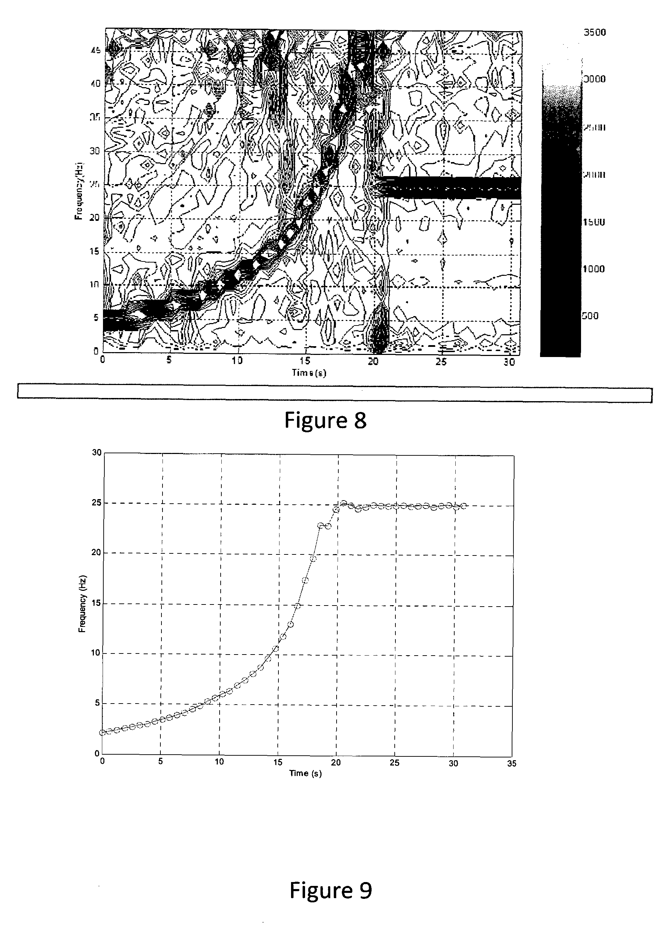

Fig. 8 is an STFT of the phase fluctuations of the experimental motor during initial acceleration of the motor ("run-up" stage).

To obtain Fig. 8, the phase fluctuations of the experimental motor were demodulated from motor current signals and further processed by STFT.

With reference to Fig. 8, it is to be noted that during the initial acceleration, the secondary eccentricity harmonic is dominant, and so the speed of the motor can be taken as half of the dominant secondary eccentricity harmonic. In contrast, once the operational speed has been reached, it is the primary eccentricity harmonic that is dominant, and the speed of the motor can be taken as being the same as the primary eccentricity harmonic.

Fig. 8 illustrates that the harmonic frequency estimated by the methods taught herein may not always measure the primary eccentricity harmonic frequency, but may instead measure other harmonic frequencies instead. In practice, an algorithm can distinguish between these different harmonic frequencies e.g. by performing some trial runs against speed information acquired from speed sensor. Provided that the order of an eccentricity harmonic frequency can be identified, the speed of the motor can be estimated using that frequency by a suitably programmed controller.

Fig. 9 is a graph comparing motor speed estimated according to the IFFT technique taught herein (o) compared with motor speed as measured by the encoder (solid line).

Fig. 9 demonstrates that the proposed IFFT technique taught herein is able to efficiently estimate the motor speed during initial acceleration of the motor.

Note that the transition to a steady state operational speed for the motor causes a slight wobble in the estimated speed, see Fig. 9.

Coupling misalignment is a very common failure in AC machines and early detection of misalignment would be helpful to maintain the performance of AC machines.

In order to prove the effectiveness of the purified space vector scheme taught herein, further experiments have been conducted with the same motor described above.

In these further experiments, the three phase motor current signals were acquired under conditions of zero misalignment, and of different levels of angular and parallel misalignment. The accurate amplitude, frequency and phase information of eccentricity component caused by coupling misalignment were calculated by high-resolution spectrum. Then, a "purified" space vector was formed as an ellipse using these accurate amplitude, frequency and phase information of relative component.

In practice, the purified space vector may be calculated by feeding in the results of Equations (17)-(19) into Equation (4).

The purified space vector can thus be viewed as a vector representing the three phase motor current in a 2D space, since it effectively represents the reference voltage as perturbed by the harmonic whose frequency has been estimated.

Fig. 10 shows purified space vectors obtained for different angular misalignments (zero, 15 minute and 30 minutes angular misalignment in a clockwise direction).

Fig. 11 shows purified space vectors obtained for different parallel misalignments (zero, 10 mm, 20 mm horizontal misalignment).

It can be seen from Fig. 10 and Fig. 11 that energy of corresponding purified space vector increased along with the worsening of misalignment.

Fig. 12 shows purified space vectors obtained for a with a stator short circuit and without a stator short circuit (i.e. with a "Healthy" circuit).

To create Fig. 12, another 2HP 4-hole Reliance PreAlert motor was specially wound for testing smaller inter-turn faults. Stator faults were simulated through taps on the windings, which could be connected to short circuit two, three and four neighbouring turns. The taps were brought to a switch box where the number of shorted turns so that a phase could be selected. The accurate amplitude, frequency and phase of supply frequency component were calculated by high-resolution spectrum and corresponding purified space vectors calculated, the results being shown in Fig. 12.

It can be seen from Fig. 12 that the length of major axis of purified space vector is changed with the onset of stator fault. It can be explained that the stator short circuit resulted in the presence of negative sequence component.

Fig. 10, Fig. 11 and Fig. 12 together demonstrate how a harmonic frequency estimated according to the novel methods taught herein can be used to estimate whether various faults exist in an AC machine.

When used in this specification and claims, the terms "comprises" and "comprising", "including" and variations thereof mean that the specified features, steps or integers are included. The terms are not to be interpreted to exclude the possibility of other features, steps or integers being present.

The features disclosed in the foregoing description, or in the following claims, or in the accompanying drawings, expressed in their specific forms or in terms of a means for performing the disclosed function, or a method or process for obtaining the disclosed results, as appropriate, may, separately, or in any combination of such features, be utilised for realising the invention in diverse forms thereof.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made without departing from the scope of the invention.

All references referred to herein are hereby incorporated by reference.

<u>REFERENCES</u>

[1] S. Nandi et al, (2001) Detection of Rotor Slot and Other Eccentricity Related Harmonics in a Three Phase Induction Motor With Different Rotor Cages IEEE Transactions on Energy Conversion, Vol. 16, No. 3, September 2001

[2] S Nandi, HA Toliyat and XD Li (2005) Condition monitoring and fault diagnosis of electrical motors - A review IEEE TRANSACTIONS ON ENERGY CONVERSION 20 (4): 719-729

[3] SMA Cruz, AJM Cardoso (2001) Stator winding fault diagnosis in three-phase synchronous and asynchronous motors, by the Extended Park's Vector Approach IEEE TRANSACTIONS ON INDUSTRY APPLICATIONS 37 (5): 1227-1233 SEP-OCT

[4] DF Shi, WJ Wang, L. S. Qu (2005) Purification and feature extraction of shaft orbits for diagnosing large rotating machinery Journal of Sound and Vibration, Vol. 279, pp. 581-600

[5] M Arkan, DK Perovic, and P Unsworth (2001) Online stator fault diagnosis in induction motors IEE Proc. Electrical Power Application. Vol. 148, pp537-547, No. 6, November

**Claims**

1. A method for estimating a frequency of a harmonic in an AC current passing to/from an AC machine, the method including:

   observing an AC current passing to/from an AC machine that includes a stator and a rotor;
   measuring phase fluctuations in the observed AC current; and
   using the measured phase fluctuations to estimate a frequency of a harmonic in the AC current.

2. A method according to claim 1, wherein measuring phase fluctuations in the observed AC current includes measuring phase fluctuations in the observed AC current so as to obtain a phase fluctuation time series having a plurality of discrete elements, wherein each discrete element of the phase fluctuation time series represents a phase fluctuation in the AC current as measured at a different time.

3. A method according to claim 1 or 2, wherein measuring each phase fluctuation in the observed AC current includes, respectively:

converting an observed AC current into a vector representing the observed AC current in a 2D reference frame; and

measuring a difference in phase between the vector representing the observed AC current and a vector representing a reference AC current in the 2D reference frame.

4. A method according to any previous claim, wherein using the measured phase fluctuations to estimate a frequency of a harmonic in the AC current includes:

converting the measured phase fluctuations into a frequency domain;

using the measured phase fluctuations in the frequency domain to estimate a frequency of a harmonic in the AC current.

5. A method according to any previous claim, wherein using the measured phase fluctuations to estimate a harmonic frequency of the AC current includes:

converting a phase fluctuation time series into a frequency domain to obtain a phase fluctuation frequency series;

using the phase fluctuation frequency series to estimate a frequency of a harmonic in the AC current.

6. A method according to claim 5, wherein using the phase fluctuation frequency series to estimate a frequency of a harmonic in the AC current includes:

identifying a peak in the phase fluctuation frequency series, wherein the peak is caused by a harmonic in the observed AC current; and

estimating the frequency of the harmonic based on the identified peak.

7. A method according to claim 5 or 6, wherein using the phase fluctuation frequency series to estimate a frequency of a harmonic in the AC current includes:

identifying adjacent peaks in the phase fluctuation frequency series, wherein the adjacent peaks are caused by a harmonic in the observed AC current; and

estimating the frequency of the harmonic by interpolating between the adjacent peaks.

8. A method according to any previous claim, wherein the method also includes estimating an amplitude and/or phase of the phase fluctuations in the frequency domain at the estimated frequency of the harmonic in the AC current.

9. A method according to any previous claim, wherein the method includes using any one or more of the estimated frequency of the harmonic in the observed AC current, an estimated amplitude of the phase fluctuations in the frequency domain at the estimated frequency, and an estimated phase of the phase fluctuations in the frequency domain at the estimated frequency, to determine one or more conditions of the AC machine.

10. A method according to any previous claim, wherein the method includes using the estimated frequency of the harmonic in the observed AC current to estimate a speed of the rotor of the AC machine.

11. A method according to any previous claim, wherein the method includes using an estimated amplitude and an estimated phase of the phase fluctuations in the frequency domain at the estimated frequency, to determine whether there is a fault with the AC machine.

12. A method according to any previous claim, wherein the method is performed whilst the AC machine is operated as an AC induction motor and/or whilst the AC machine is operated as an AC induction generator.

13. A controller for an AC machine, the controller being configured to:

observe an AC current passing to/from an AC machine that includes a stator and a rotor;
measure phase fluctuations in the observed AC current; and
use the measured phase fluctuations to estimate a frequency of a harmonic in the AC current.

**14.** An apparatus including:

an AC machine including a stator and a rotor; and
a controller according to claim 13.

**15.** Machine-executable instructions configured to cause a controller, or an apparatus including a controller, to perform a method according to any one of claims 1 to 12.

Figure 1

Figure 2

100

101                    160              170              150

```
┌──────────┐  Vd*  ┌──────────┐      ┌──────────┐      ┌──────────┐
│          │──────▶│          │─────▶│          │─────▶│          │
│Controller│  Vq*  │Modulator │─────▶│ Inverter │─────▶│    AC    │
│          │──────▶│          │      │          │      │ Machine  │
│          │       │          │─────▶│          │─────▶│          │
└──────────┘       └──────────┘      └──────────┘      └──────────┘
```

Ia

Ib

Figure 3

Figure 4

Figure 5

Figure 6

Figure 7

Figure 8

Figure 9

Figure 10

Figure 11

Figure 12

Europäisches
Patentamt

European
Patent Office

Office européen
des brevets

## EUROPEAN SEARCH REPORT

Application Number

EP 13 00 5360

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DONGFENG SHI ET AL: "Sensorless speed measurement of induction motor using Hilbert transform and interpolated fast Fourier transform", IEEE TRANSACTIONS ON INSTRUMENTATION AND MEASUREMENT IEEE USA, vol. 55, no. 1, February 2006 (2006-02), pages 290-299, XP002720817, ISSN: 0018-9456, DOI: 10.1109/TIM.2005.860870 * the whole document * | 1-15 | INV. G01R23/20 G01R19/25 |
| X | WANG C ET AL: "Sensorless speed measurement of induction machines using Short Time Fourier Transformation", POWER ELECTRONICS, ELECTRICAL DRIVES, AUTOMATION AND MOTION, 2008. SPEEDAM 2008. INTERNATIONAL SYMPOSIUM ON, IEEE, PISCATAWAY, NJ, USA, 11 June 2008 (2008-06-11), pages 1114-1119, XP031293220, ISBN: 978-1-4244-1663-9 * the whole document * | 1-15 | |

TECHNICAL FIELDS SEARCHED (IPC)

G01R

The present search report has been drawn up for all claims

| Place of search | Date of completion of the search | Examiner |
|---|---|---|
| Berlin | 10 March 2014 | Binger, Bernard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. NANDI et al.** Detection of Rotor Slot and Other Eccentricity Related Harmonics in a Three Phase Induction Motor With Different Rotor Cages. *IEEE Transactions on Energy Conversion,* September 2001, vol. 16 (3
- **S NANDI ; HA TOLIYAT ; XD LI.** Condition monitoring and fault diagnosis of electrical motors - A review. *IEEE TRANSACTIONS ON ENERGY CONVERSION,* 2005, vol. 20 (4), 719-729

- **SMA CRUZ ; AJM CARDOSO.** Stator winding fault diagnosis in three-phase synchronous and asynchronous motors, by the Extended Park's Vector Approach. *IEEE TRANSACTIONS ON INDUSTRY APPLICATIONS,* September 2001, vol. 37 (5), 1227-1233
- **DF SHI ; WJ WANG ; L. S. QU.** Purification and feature extraction of shaft orbits for diagnosing large rotating machinery. *Journal of Sound and Vibration,* 2005, vol. 279, 581-600
- **M ARKAN ; DK PEROVIC ; P UNSWORTH.** Online stator fault diagnosis in induction motors. *IEE Proc. Electrical Power Application,* November 2001, vol. 148 (6), 537-547